# EUROPEAN PATENT APPLICATION

(11) **EP 4 664 126 A1**
(43) Date of publication of application: **17.12.2025**
(21) Application number: 23921276.4
(22) Date of filing: 26.10.2023
(51) Int. Cl.: G01R 31/34, G01R 31/00

(54) **POWER CONVERSION DEVICE, EQUIPMENT SYSTEM, AND ABNORMALITY DIAGNOSIS METHOD**

(30) Priority: 07.02.2023 JP 2023016889
(71) Applicant: Hitachi Industrial Equipment Systems Co., Ltd., Tokyo 101-0021 (JP)
(72) Inventor: NAKAMURA Akihiro, Tokyo 100-8280 (JP); KANEKO Satoru, Tokyo 100-8280 (JP); OJIMA Masayoshi, Tokyo 101-0021 (JP)
(74) Representative: MERH-IP Matias Erny Reichl Hoffmann Patentanwälte PartG mbB
(86) International application number: PCT/JP2023/038704
(87) International publication number: WO 2024/166452

(57) **Abstract**

The present invention comprises: a diagnostic condition determination unit that determines a predetermined diagnostic condition on the basis of a diagnostic frequency, motor speed, and output voltage modulation rate for performing abnormality diagnosis; a control change unit that reduces the modulation rate on the basis of the determination result of the diagnostic condition determination unit; and an abnormality diagnosis unit that performs equipment abnormality diagnosis from a motor current on the basis of the determination result of the diagnostic condition determination unit.

## Description

### TECHNICAL FIELD

The present invention relates to a power conversion device, an equipment system, and an abnormality diagnosis method.

### BACKGROUND ART

In recent years, the spread of IoT (Internet of Things), the advancement of AI (Artificial Intelligence), and the decline in the working population have all coincided, and technologies have been developed to diagnose abnormalities in machinery and equipment using information obtained by sensors, etc., with the aim of improving efficiency of maintenance work and reducing the number of workers required.

Among these technologies, attention has been focused on abnormality diagnosis technology using motor current in which a sensor can be easily installed and a single sensor can be used to collectively monitor a motor itself and a mechanical part connected to the motor.

For example, Patent Document 1 discloses technology for diagnosing the presence or absence of an abnormality by converting motor current acquired as time-series data into a frequency spectrum and comparing a specific frequency component (amplitude values) caused by a mechanical part, an abnormality of which is to be detected, with a frequency component acquired under normal conditions.

### CITATION LIST

### PATENT DOCUMENT

Patent Document 1: JP 2020-34037 A

### SUMMARY OF THE INVENTION

### PROBLEMS TO BE SOLVED BY THE INVENTION

However, when a method of Patent Document 1 is applied to a motor system using a power conversion device (inverter) that performs asynchronous PWM (Pulse Width Modulation) control, the following problems may occur.

In the power conversion device, a pulse width-modulated sine wave voltage is supplied to a motor. However, when the load increases or an input voltage to the power conversion device decreases, the voltage supplied to the motor may become overmodulated (an output voltage command value calculated in the power conversion device exceeds an input voltage level of the power conversion device).

In such a state, a voltage waveform becomes closer to a square wave rather than a sine wave, and harmonic components (harmonic noise) of a fundamental frequency of the output voltage increase. In this case, when a specific frequency caused by a mechanical part illustrated in Patent Document 1 is close to the harmonic, the frequency components may increase even in a situation where no abnormality is occurring, resulting in erroneous diagnosis.

An object of the invention is to prevent erroneous diagnosis when performing abnormality diagnosis for equipment driven by a motor in a power conversion device.

### SOLUTIONS TO PROBLEMS

A power conversion device of an aspect of the invention is a power conversion device configured to perform abnormality diagnosis for equipment driven by a motor, the power conversion device including a motor control unit configured to control a motor current of the motor, a motor speed of the motor, and an output voltage of the power conversion device, a diagnostic condition determination unit configured to determine a predetermined diagnostic condition based on a diagnostic frequency, the motor speed, and a modulation rate of the output voltage for performing the abnormality diagnosis, a control change unit configured to reduce the modulation rate based on a determination result of the diagnostic condition determination unit, and an abnormality diagnosis unit configured to perform the abnormality diagnosis for the equipment from the motor current based on the determination result of the diagnostic condition determination unit.

### EFFECTS OF THE INVENTION

According to an aspect of the invention, it is possible to prevent erroneous diagnosis when performing abnormality diagnosis for equipment driven by a motor in a power conversion device.

### BRIEF DESCRIPTION OF THE DRAWINGS

Fig. 1 is a system configuration diagram of a first embodiment of the invention.
Fig. 2 is a diagram illustrating processing content of a diagnostic frequency setting unit 7.
Fig. 3 is a diagram illustrating processing content of a diagnostic condition determination unit 8.
Fig. 4 is a diagram illustrating patterns when determining a state transition signal.
Fig. 5 is a diagram illustrating processing content of a control change unit 9.
Fig. 6 is a diagram illustrating other processing content of the control change unit 9.
Fig. 7 is a diagram illustrating other processing content of the control change unit 9.
Fig. 8 is a diagram illustrating other processing content of the control change unit 9.
Fig. 9 is a diagram illustrating an example of a current waveform before and after reduction in a modulation rate.
Fig. 10 is a diagram illustrating processing content of an abnormality diagnosis unit 10.
Fig. 11 is a basic timing chart of processing.
Fig. 12 is a system configuration diagram of a second embodiment of the invention.
Fig. 13 is a system configuration diagram of a third embodiment of the invention.
Fig. 14 is a system configuration diagram of a fourth embodiment of the invention.

### MODE FOR CARRYING OUT THE INVENTION

Hereinafter, the embodiments will be described with reference to the drawings.

### First embodiment

In a first embodiment of the invention, a description will be given of a power conversion device having an abnormality diagnosis function that reduces harmonic noise generated from the power conversion device and reduces the number of times of occurrence of erroneous diagnosis.

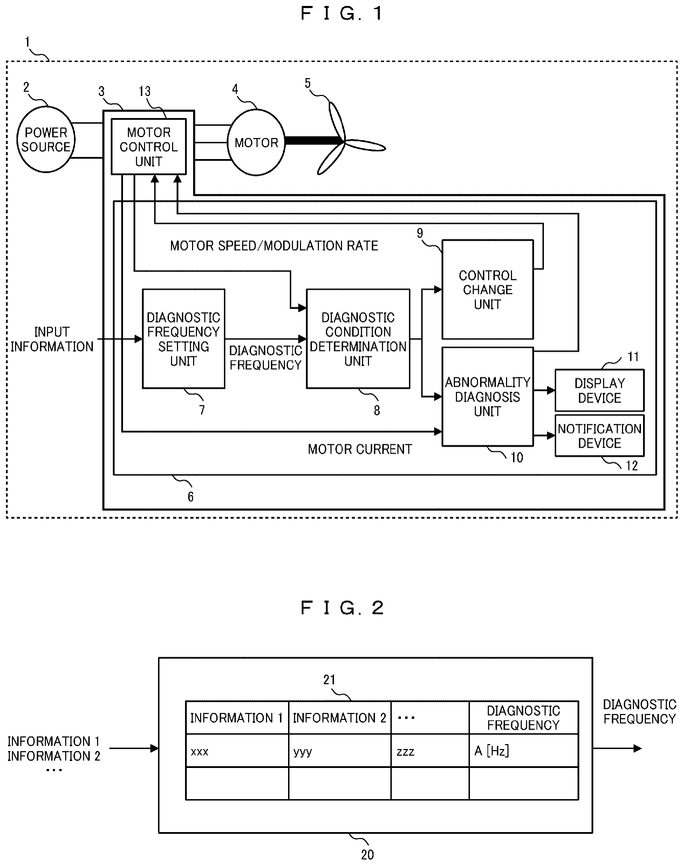

Fig. 1 is a system configuration diagram of the first embodiment. In this example, a system for driving a fan (blower) will be described as an example, but the invention is applicable regardless of the equipment driven by a motor.

The fan system 1 includes a power source 2 which is alternate current (AC) or direct current (DC) (in this example, DC will be used), a power conversion device 3 driven by the power source 2, and a motor 4 and a fan 5 driven by a three-phase AC voltage/current supplied from the power conversion device 3.

Here, the inside of the power conversion device 3 in the first embodiment is divided into a motor control unit 13 and an abnormality diagnosis system 6, and the motor control unit 13 calculates various command values to control a motor current, an output voltage, a motor speed, and motor torque. In this example, it is assumed that an output voltage of the power conversion device 3 is subjected to asynchronous PWM control.

Meanwhile, the abnormality detection system 6 includes a diagnostic frequency setting unit 7 that sets a motor speed (diagnostic frequency) at which abnormality diagnosis is performed, a diagnostic condition determination unit 8 that receives as input the diagnostic frequency, a motor speed obtained from the motor control unit 13, and a modulation rate of the output voltage of the power conversion device 3, and determines whether abnormality diagnosis can be performed or whether it is necessary to reduce the modulation rate of the output voltage of the power conversion device 3, and a control change unit 9 and an abnormality diagnosis unit 10 that reduce the modulation rate of the output voltage of the power conversion device 3 in accordance with a result of the diagnostic condition determination unit 8.

Further, diagnosis results of the abnormality diagnosis unit 10 are input to a display device 11 indicating a display, etc., a notification device 12 indicating a speaker, a lamp, etc., and the motor control unit 13, using wired or wireless communication means. From here, details of each processing block will be described.

First, the diagnostic frequency setting unit 7 sets a motor speed (diagnostic frequency) for performing diagnosis based on information input from outside. For example, a name or an abnormal state of a target part may be input as external input information, and a diagnostic frequency may be determined by searching a database 21 stored in a diagnostic frequency search unit 20 as illustrated in Fig. 2. Note that a plurality of diagnostic frequencies may be output for each mechanical part to be diagnosed. The following description will be given on the assumption that one diagnostic frequency has been set.

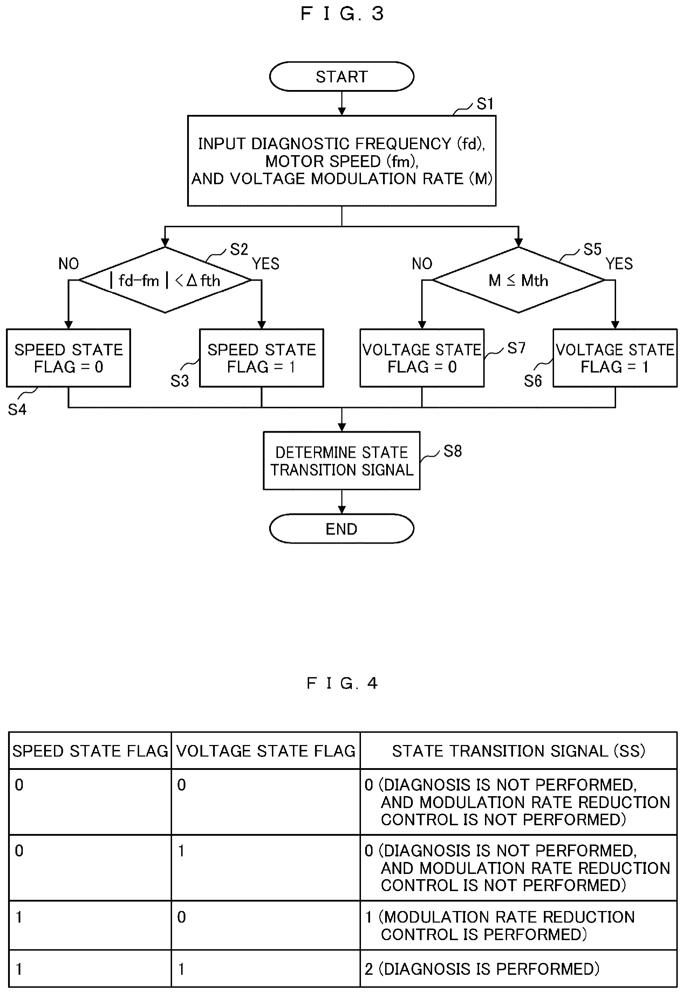

Next, the diagnostic condition determination unit 8 performs processing illustrated in Fig. 3.

First, a diagnostic frequency fd, a motor speed fm, and a modulation rate M of an output voltage of the power conversion device are input (S1). In this instance, for example, a value of a sensor that measures a motor speed or an estimated value of a motor speed may be used as fm, and a fundamental frequency of a motor current may be used as fm.

Moreover, the modulation rate M is typically a value defined by "amplitude (peak-to-peak) of an output voltage command value/an input DC voltage value of the power conversion device", "amplitude (peak-to-peak) of the output voltage command value/amplitude (peak-to-peak) of a PWM carrier (carrier wave)", etc. After the information is input, condition determination is performed for each of the motor speed and the modulation rate.

In determining the motor speed, it is determined whether |fd - fm| is smaller than a threshold Δfth (for example, within 5% of fd) (S2). In the case of yes, a speed state flag is set to 1 (S3), and in the case of no, the speed state flag is set to 0 (S4).

Meanwhile, in determining the modulation rate, it is determined whether the modulation rate M is equal to or less than a threshold Mth (generally set to 1) (S5), and in the case of yes, the voltage state flag is set to 1 (S6), and in the case of no, the voltage state flag is set to 0 (S7). In this instance, the modulation rate M may be an instantaneous value or an average value over a certain time range in the past.

Thereafter, in step (S8) of determining a state transition signal, for example, the state transition signal is determined according to a rule of Fig. 4. Note that it is presumed that, even when the motor speed or the modulation rate changes during the subsequent processing, a flag value determined above is maintained until next condition determination is performed. A reason therefor is to suppress frequent switching of state transition caused by instantaneous flag change when the motor speed or the modulation rate changes near the threshold. Then, the control change unit 9 and the abnormality diagnosis unit 10 are executed based on the state transition signal.

As illustrated in Fig. 4, when the speed state flag is 0 and the voltage state flag is 0, the state transition signal (SS) is 0, and neither modulation rate reduction control nor abnormality diagnosis is performed. Here, the speed state flag being 0 indicates, for example, a state in which the motor 4 is stopped.

In addition, when the speed state flag is 0 and the voltage state flag is 1, the state transition signal (SS) is 0, and neither modulation rate reduction control nor abnormality diagnosis is performed.

In addition, when the speed state flag is 1 and the voltage state flag is 0, the state transition signal (SS) is 1, and modulation rate reduction control is performed.

In addition, when the speed state flag is 1 and the voltage state flag is 1, the state transition signal (SS) is 2, and abnormality diagnosis is performed.

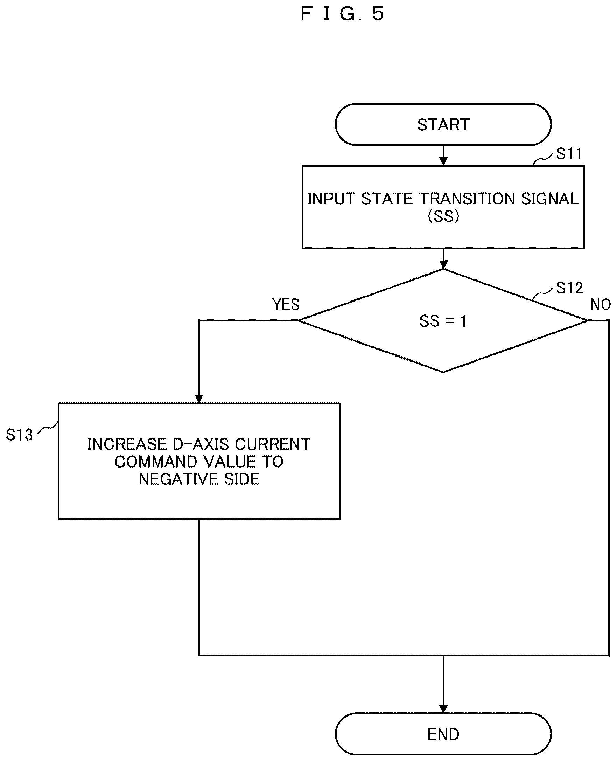

When the state transition signal SS is 1, the modulation rate of the output voltage of the power conversion device 3 is greater than the threshold, that is, the device is in an overmodulation state that generates harmonic noise affecting diagnosis, so it is necessary to reduce the modulation rate to reduce noise. Therefore, the control change unit 9 executes modulation rate reduction control as illustrated in Figs. 5, 6, 7, and 8.

Fig. 5, it is assumed that the motor 4 is a magnet motor, and a current component that controls the motor magnetic flux, referred to as a d-axis current command value, is increased to a negative side (S13). When such control is executed, the magnetic flux generated by the motor itself is reduced, thereby lowering an induced voltage of the motor, and a required voltage output from the power conversion device 3 is reduced, so that the modulation rate can be reduced.

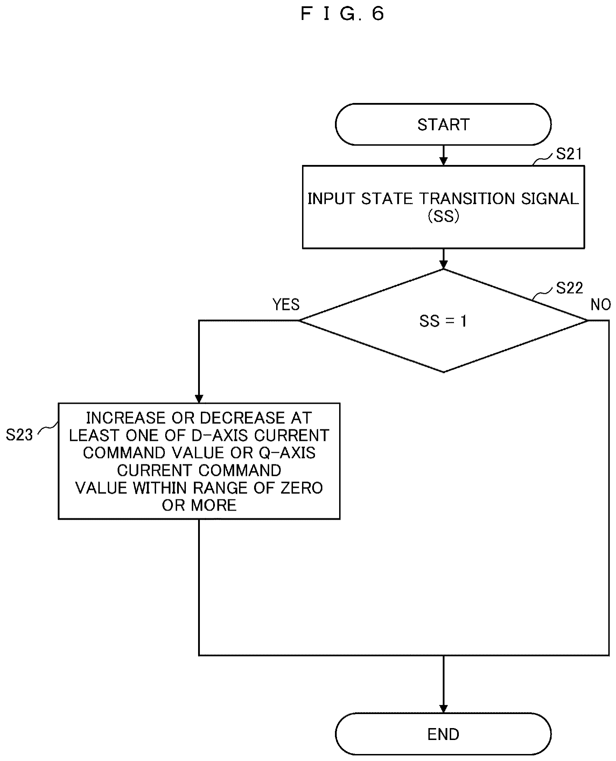

In addition, in Fig. 6, assuming the case of an induction motor, at least one of the d-axis current command value and a q-axis current command value, which is a current component that controls the motor torque, is increased or decreased within a range of zero or more. In the induction motor, the output voltage of the power conversion device 3 changes depending on the relationship between a d-axis current, a q-axis current, and the motor speed. Therefore, the q-axis current command value or the d-axis current command value is not only decreased but also increased, and adjustment is performed so that the output voltage decreases.

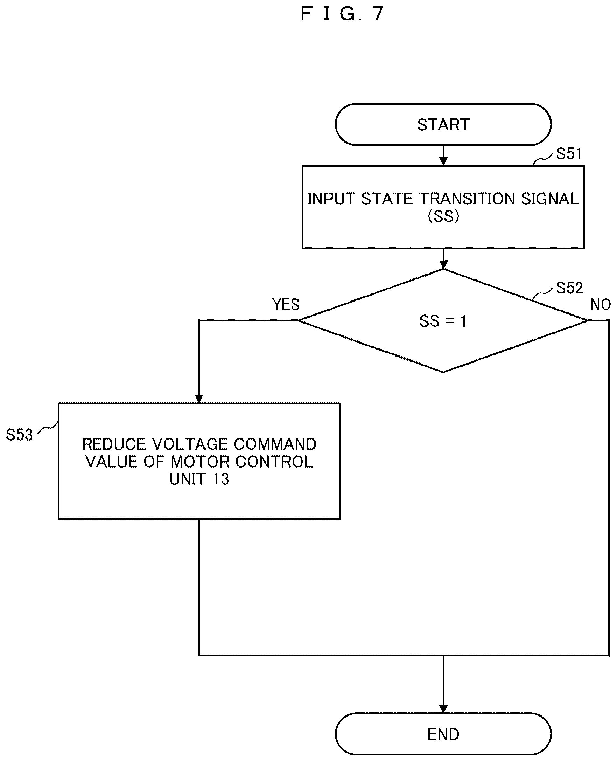

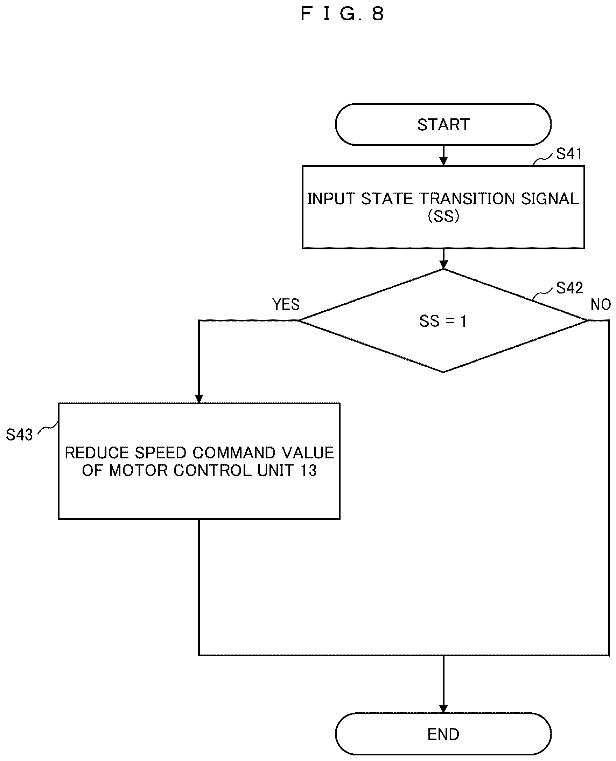

In addition, each of Figs. 7 and 8 illustrates a method of reducing the modulation rate by reducing the amplitude of the output voltage command value of the power conversion device 3 or a motor speed command value rather than changing the current command value (see (S53) of Fig. 7 and (S43) of Fig. 8).

As mentioned above, the amplitude of the output voltage command value is a direct value that determines the modulation rate, and when an amplitude value is decreased, the modulation rate also decreases. In addition, the motor speed command value has an effect of lowering the modulation rate in the case of an application such as a fan where the load greatly increases or decreases depending on the speed.

That is, the speed is reduced to lower the load, and as a result, the required voltage is reduced to lower the modulation rate. Note that, when executing control illustrated in Figs. 6, 7, and 8, a speed reduction of about several percent is permitted. Furthermore, such control change may be performed in steps, or may be changed by setting a time rate.

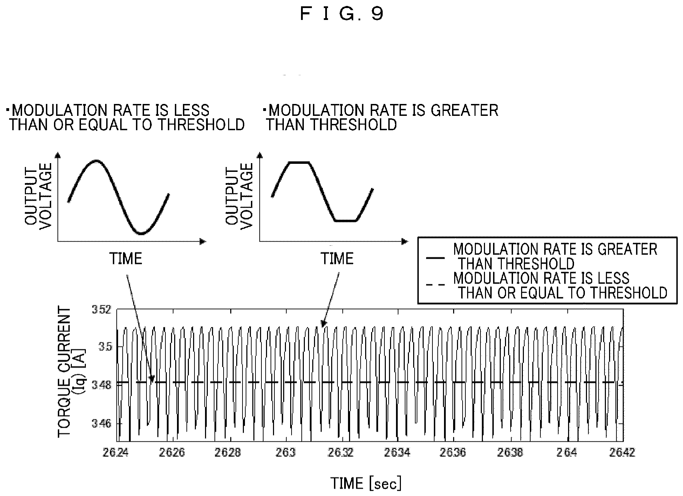

By implementing this type of control, as illustrated in Fig. 9, a voltage waveform changes from a nearly square wave (a sine wave with limited up and down limits) to a sine wave, high frequency noise superimposed on the current is reduced, and it is possible to obtain a motor current suitable for diagnosis (Fig. 9 illustrates an ideal waveform with no abnormal vibration).

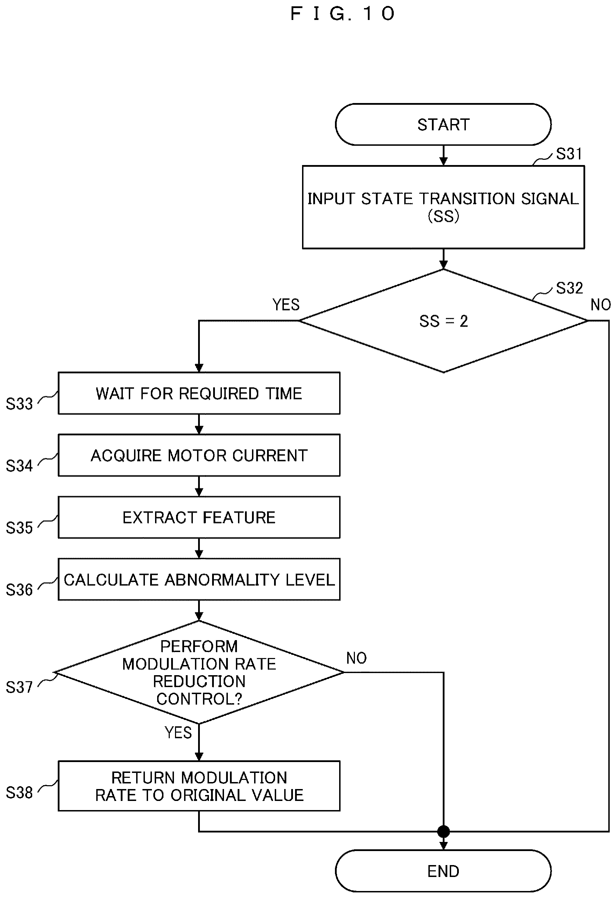

Then, after control for reducing the modulation rate is performed, or when the state transition signal SS indicating that the modulation rate is originally smaller than the threshold is 2, a flow of abnormality diagnosis illustrated in Fig. 10 is executed.

In abnormality diagnosis, first, the modulation rate is reduced and then waiting is performed for a required time (S33). This is performed to wait for a transient effect of reduction in the modulation rate to settle down, and is preferably set in advance according to target equipment since this varies depending on the set state of motor control, the magnitude of motor inertia, etc.

Next, the motor current is acquired (S34), and then a feature for diagnosis is extracted from the motor current (S35). Here, the motor current may be a phase current or torque current itself, or a time-series signal calculated therefrom. The feature needs to be changed depending on the target equipment and the type of abnormality, and examples of a candidate therefor include a statistical index representing an average value or variance of the time-series signal, and a specific frequency component obtained by subjecting the time-series signal to frequency conversion, etc.

After feature extraction, the feature may be subjected to threshold determination to calculate binary information of normal/abnormal, or a degree of abnormality may be numerically calculated using an MT method or one-class SVM, which is one of machine learning methods. In addition, a model for classifying types of abnormality may be prepared based on a decision tree, and a state or type of abnormality may be output (S36). In this example, either case is referred to as calculating an abnormality level.

Further, when a control operation has been executed to reduce the modulation rate before performing abnormality diagnosis, processing is performed to return the modulation rate an original value thereof (S37 and S38). When returning the modulation rate to the original value, this processing may be performed in steps, or the modulation rate may be changed by setting a time rate.

Finally, the calculated abnormality level is input to the display device 11, the notification device 12, or the motor control device 13 using a communication means such as wired or wireless communication, and is reported to an operator or a machine. For example, a binary state of normal/abnormality may be input to the lamp or the speaker, which is an example of the notification device 12, and notify the operator of the state by light or sound. In addition, a numerical abnormality level may be displayed on the display device 11. Furthermore, when an abnormality diagnosis result is input to the motor control device 13, the abnormality level may be used to automatically stop or change an operation of the target equipment.

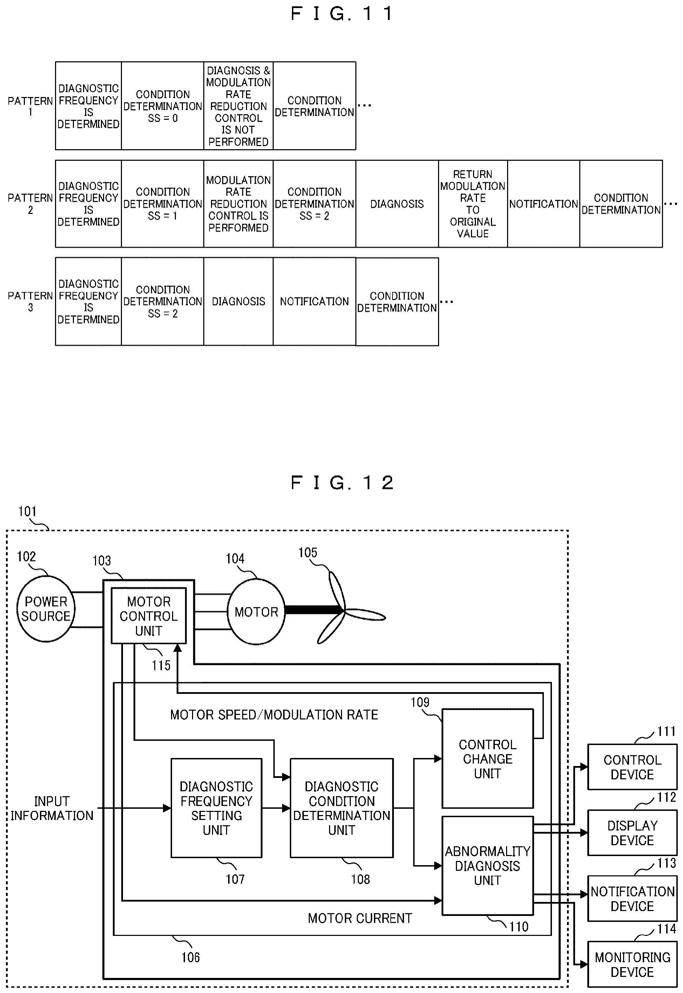

A process flow illustrated so far is summarized again as a time chart in Fig. 11.

A basic process flow roughly has three patterns. A first pattern is pattern 1 in which SS = 0 (diagnosis is not performed) is obtained in condition determination, a second pattern is pattern 2 in which condition determination is changed from SS = 1 (modulation rate reduction control is executed) to SS = 2, and a third pattern is pattern 3 in which SS = 2 (diagnosis is executed) is obtained.

Note that, in Fig. 11, condition determination is performed immediately after the end of each processing pattern, but condition determination may be performed at specific time intervals or irregularly.

In this way, according to the first embodiment, it is possible to reduce harmonic noise generated from the power conversion device and reduce the number of times of occurrence of erroneous diagnosis.

### Second embodiment

In a second embodiment of the invention, a description will be given of another power conversion device having an abnormality diagnosis function that reduces harmonic noise generated from the power conversion device and reduces the number of times of occurrence of erroneous diagnosis.

Note that a description of the same processing as that in the first embodiment will be omitted, and the description will focus on a difference from the first embodiment.

Fig. 12 illustrates a system diagram of the second embodiment. The difference between the second embodiment and the first embodiment is that output of an abnormality diagnosis unit 110 is input to a control device 111, a display device 112, a notification device 113, and a monitoring device 114 that are present outside a power conversion device 103. The display device 112 and the notification device 113 are the same as those described in the first embodiment.

Meanwhile, the control device 111 is a control device (such as a PLC) located at an upper level of the motor control unit 115 or an upper-level control device that controls the entire factory. In addition, the monitoring device 114 is a monitoring device for other equipment or the entire factory.

In this way, according to the second embodiment, a notification function that should be provided in the power conversion device can be simplified compared to the first embodiment, so that the power conversion device can be inexpensively configured.

### Third embodiment

In a third embodiment of the invention, a description will be given of another power conversion device having an abnormality diagnosis function that reduces harmonic noise generated from the power conversion device and decreases the number of times of occurrence of erroneous diagnoses.

Note that a description of the same processing as that in the first embodiment will be omitted, and the description will focus on a difference from the first embodiment.

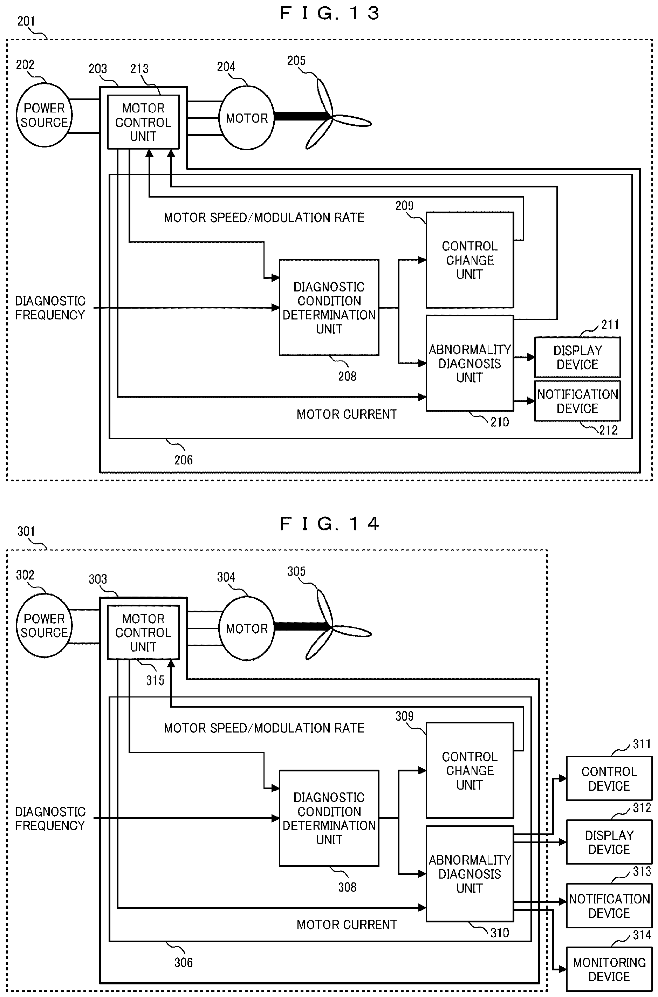

Fig. 13 illustrates a system diagram of the third embodiment. A difference between the third embodiment and the first embodiment is that the diagnostic frequency setting unit 7 illustrated in the first embodiment is not present. In the second embodiment, the diagnostic frequency is directly input to the diagnostic condition determination unit 208. In this case, the diagnostic frequency may be determined from an external database, etc.

In this way, according to the third embodiment, by eliminating some of the functions implemented in the power conversion device 203, processing is made lighter than that in the first embodiment, and the storage burden can be reduced by reducing the amount of information that needs to be stored.

### Fourth embodiment

In a fourth embodiment of the invention, a description will be given of another power conversion device having an abnormality diagnosis function that reduces harmonic noise generated from the power conversion device and decreases the number of times of occurrence of erroneous diagnoses.

Note that a description of the same processing as that in the first, second, and third embodiments will be omitted, and the description will focus on a difference from the third embodiment.

Fig. 14 illustrates a system diagram of the fourth embodiment. The difference between the fourth embodiment and the third embodiment is that output of an abnormality diagnosis unit 310 is input to a control device 311, a display device 312, a notification device 313, and a monitoring device 314, which are outside a power conversion device 303. The display device 312 and the notification device 313 are the same as those described in the first embodiment. In addition, the control device 311 and the monitoring device 314 are the same as those described in the second embodiment.

In this way, according to the fourth embodiment, by deleting some of the functions, processing is made lighter than that of the first and second embodiments, and the amount of information to be stored is reduced, so that the storage burden can be reduced. In addition, since the notification function to be provided in the power conversion device can be simplified when compared to the third embodiment, the power conversion device can be configured at low cost.

Here, for example, the power conversion device 3 illustrated in Fig. 1 includes a computer having a memory and a processor (a CPU, etc.).

A function of a "unit" illustrated in Fig. 1 is realized, for example, by the processor executing a program.

For example, in the motor control unit 13 illustrated in Fig. 1, a motor control function is realized by the processor executing a program. The diagnostic frequency setting unit 7 illustrated in Fig. 1 realizes a diagnostic frequency setting function by the processor executing a program.

In the diagnostic condition determination unit 8 illustrated in Fig. 1, a diagnostic condition determination function is realized by the processor executing a program. In the control change unit 9 illustrated in Fig. 1, a control change function is realized by the processor executing a program. In the abnormality diagnosis unit 10 illustrated in Fig. 1, an abnormality diagnosis function is realized by the processor executing a program.

According to the embodiments, it is possible to reduce harmonic noise generated from a power conversion device and to reduce the number of times of occurrence of erroneous diagnosis.

### REFERENCE SIGNS LIST

- 1: Fan system
- 2: Power source
- 3: Power conversion device
- 4: Motor
- 5: Fan
- 6: Abnormality diagnosis system
- 7: Aiagnostic frequency setting unit
- 8: Diagnostic condition determination unit
- 9: Control change unit
- 10: Abnormality diagnosis unit
- 11: Display device
- 12: Notification device
- 13: Motor control unit

## Claims

1. A power conversion device configured to perform abnormality diagnosis for equipment driven by a motor, the power conversion device comprising:
a motor control unit configured to control a motor current of the motor, a motor speed of the motor, and an output voltage of the power conversion device;
a diagnostic condition determination unit configured to determine a predetermined diagnostic condition based on a diagnostic frequency, the motor speed, and a modulation rate of the output voltage for performing the abnormality diagnosis;
a control change unit configured to reduce the modulation rate based on a determination result of the diagnostic condition determination unit; and
an abnormality diagnosis unit configured to perform the abnormality diagnosis for the equipment from the motor current based on the determination result of the diagnostic condition determination unit.

2. The power conversion device according to claim 1, further comprising a diagnostic frequency setting unit configured to set the diagnostic frequency serving as the motor speed for performing the abnormality diagnosis.

3. The power conversion device according to claim 1, further comprising a display device or a notification device configured to report a result of the abnormality diagnosis for the equipment performed by the abnormality diagnosis unit.

4. The power conversion device according to claim 1, wherein a result of the abnormality diagnosis for the equipment performed by the abnormality diagnosis unit is input to the motor control unit.

5. The power conversion device according to claim 1, wherein:
the power conversion device supplies a voltage of a pulse width-modulated sine wave to the motor,
a waveform of the output voltage before performing the abnormality diagnosis is a square wave obtained by limiting upper and lower limits of the sine wave,
a waveform of the output voltage before performing the abnormality diagnosis becomes the sine wave, and
a waveform of the output voltage after performing the abnormality diagnosis returns to the square waveform.

6. The power conversion device according to claim 1, wherein:
the diagnostic condition determination unit is configured to:
output an abnormality diagnosis performance determination flag indicating that the abnormality diagnosis is to be performed when the motor speed matches the diagnostic frequency within a certain value and the modulation rate is less than or equal to a threshold,
output a modulation rate reduction control performance determination flag indicating that control for reducing the modulation rate is to be performed when the motor speed matches the diagnostic frequency within the certain value and the modulation rate is greater than the threshold,
output a non-performance determination flag indicating that neither the abnormality diagnosis nor the control for reducing the modulation rate is to be performed when a difference between the motor speed and the diagnostic frequency is greater than or equal to the certain value, and
determine the predetermined diagnostic condition by referring to the abnormality diagnosis performance determination flag, the modulation rate reduction control performance determination flag, and the non-performance determination flag,
the control change unit reduces the modulation rate by referring to the modulation rate reduction control performance determination flag, and
the abnormality diagnosis unit performs the abnormality diagnosis of the equipment by referring to the abnormality diagnosis performance determination flag.

7. The power conversion device according to claim 1, wherein the control change unit reduces the modulation rate by increasing a d-axis current command value calculated by the motor control unit to a negative side.

8. The power conversion device according to claim 1, wherein the control change unit reduces the modulation rate by increasing or decreasing at least one of a d-axis current command value and a q-axis current command value calculated by the motor control unit within a range of zero or more.

9. The power conversion device according to claim 1, wherein the control change unit reduces the modulation rate by reducing a voltage command value calculated by the motor control unit.

10. The power conversion device according to claim 1, wherein the control change unit reduces the modulation rate by reducing a speed command value calculated by the motor control unit.

11. The power conversion device according to claim 1, wherein the abnormality diagnosis unit is configured to:
perform the abnormality diagnosis by calculating an abnormality level using a feature extracted from the motor current, and
return the modulation rate to a state before performing the abnormality diagnosis when control for reducing the modulation rate is performed by the control change unit.

12. An equipment system comprising:
equipment driven by a motor; and
a power conversion device configured to control the motor,
wherein the power conversion device comprises:
a motor control unit configured to control a motor current of the motor, a motor speed of the motor, and an output voltage of the power conversion device;
a diagnostic condition determination unit configured to determine a predetermined diagnostic condition based on a diagnostic frequency, the motor speed, and a modulation rate of the output voltage for performing the abnormality diagnosis;
a control change unit configured to reduce the modulation rate based on a determination result of the diagnostic condition determination unit; and
an abnormality diagnosis unit configured to perform the abnormality diagnosis for the equipment from the motor current based on the result of the diagnostic condition determination unit.

13. The equipment system according to claim 12, wherein the equipment is a fan or a pump.

14. The equipment system according to claim 12, further comprising a display device or a notification device configured to report a result of the abnormality diagnosis for the equipment performed by the abnormality diagnosis unit.

15. An abnormality diagnosis method using a power conversion device configured to perform abnormality diagnosis for equipment driven by a motor, the abnormality diagnosis method comprising:
a motor control step of controlling a motor current of the motor, a motor speed of the motor, and an output voltage of the power conversion device;
a diagnostic condition determination step of determining a predetermined diagnostic condition based on a diagnostic frequency, the motor speed, and a modulation rate of the output voltage for performing the abnormality diagnosis;
a control change step of reducing the modulation rate based on a determination result of the diagnostic condition determination unit; and
an abnormality diagnosis step of performing the abnormality diagnosis for the equipment from the motor current based on a result of the diagnostic condition determination unit.
